# FASCICULE DE BREVET EUROPEEN

(11) **EP 2 507 825 B1**
(45) Date de publication et mention de la délivrance du brevet: **12.02.2014**
(21) Numéro de dépôt: 10773931.0
(22) Date de dépôt: 10.11.2010
(51) Int. Cl.: H01L 21/50, H01L 23/10

(54) **PROCEDE D'ASSEMBLAGE HERMETIQUE D'UN BOÎTIER ELECTRONIQUE HERMETIQUE**
VERFAHREN ZUR MONTAGE UND ABDICHTUNG EINES GEHÄUSES
METHOD FOR THE SEALED ASSEMBLY OF A SEALED ELECTRONIC HOUSING

(30) Priorité: 04.12.2009 FR 0905873
(43) Date de publication de la demande: 10.10.2012
(73) Titulaire: THALES, 92200 Neuilly sur Seine (FR)
(72) Inventeur: DREVON, Claude, F-31500 Toulouse (FR); VENDIER, Olivier, F-31120 Lacroix-falgarde (FR); BEN NACEUR, Walim Thales Alenia Space, 31037 Toulouse Cedex 1 (FR)
(74) Mandataire: Esselin, Sophie
(86) Numéro de dépôt international: PCT/EP2010/067228
(87) Numéro de publication internationale: WO 2011/067085

(56) Documents cités:
- EP-A1- 2 124 254
- WO-A1-2009/116136
- US-A1- 2005 023 661
- US-A1- 2005 274 227
- US-A1- 2008 231 145

## Description

Le domaine de l'invention est celui des boîtiers électroniques hermétiques renfermant en leur intérieur, au sein d'une cavité, au moins un composant électronique. Le rôle du boîtier est primordial car il influence directement les performances et la fiabilité des fonctions électriques réalisées par les composants électroniques qu'il intègre ainsi que les coûts et les rendements de fabrication. La fonction première d'un boîtier consiste à protéger la fonction électronique qu'il contient de l'environnement extérieur. La fiabilité des composants électroniques est sensible aux gaz présents dans la cavité ainsi qu'au taux d'humidité de ladite cavité. Il est primordial d'assurer la fermeture hermétique des boîtiers de sorte à préserver l'atmosphère en termes de composition en gaz ainsi qu'en termes de taux d'humidité nécessaires au bon fonctionnement des composants encapsulés (par exemple l'entrée d'hydrogène, qui détériore les puces en Arséniure de Gallium AsGa est évitée, au sein du boîtier, lorsque celui-ci est hermétique.)

Le document US2008/0231145 décrit un procédé pour calfeutrer hermétiquement un module de cristal de quartz.

On connaît des boîtiers hermétiques obtenus par assemblage hermétique d'un support et d'un capot au moyen d'une soudure à la molette. Or, la fermeture à la molette nécessite que la taille du boîtier soit suffisamment importante (longueur et largeur supérieures à environ 10mm) pour éviter les interférences mécaniques ou électriques entre les molettes durant la fermeture.

On connaît également des boîtiers fermés hermétiquement au moyen d'une brasure de type eutectique, par exemple, d'AuSn. Or, les procédés de brasage basés sur des eutectiques présentent l'inconvénient d'être mis en oeuvre à des températures importantes de l'ordre de 300°C qui détériorent les performances des fonctions électroniques réalisées par les composants encapsulés par le boîtier. En effet, ces températures élevées détériorent par effets thermo-élastiques les composants électroniques qui sont particulièrement sensibles aux hautes températures et/ou les jonctions entre ces composants et le boîtier. Par ailleurs, si les jonctions sont réalisées par collage, elles sont détériorées par dégazage des colles à ces températures. En outre, lorsque le procédé est mal maîtrisé, des composés intermétalliques non désirés se forment lors du brasage, ce qui fragilise le joint de brasure de fermeture du boîtier.

On connaît également des boîtiers hermétiques obtenus en collant le support au capot. Le collage est facile à mettre en oeuvre mais ils présentent l'inconvénient de ne pas garantir une bonne herméticité du boîtier car les matériaux organiques compris dans les colles sont perméables, à plus ou moins long terme, à l'humidité.

On connaît aussi des boîtiers hermétiques obtenus en assemblant le support et le capot au moyen de verres de scellement. Ce type de procédé permet d'obtenir des boîtiers présentant une bonne herméticité. Cependant, ces procédés de scellement présentent l'inconvénient d'être mis en oeuvre à des températures élevées de l'ordre de 350 à 400°C ce qui détériore les composants électroniques à encapsuler où les jonctions entre les composants et le support.

On connaît par ailleurs des boîtiers assemblés hermétiquement par création de composés intermétalliques à l'interface entre le capot et le support. Ces boîtiers présentent l'avantage de nécessiter des températures d'assemblage relativement basses (à partir de 150°C) et, une fois créés, de résister à des températures plus élevées (de l'ordre de 200°C). Mais l'assemblage d'un boîtier basé sur la création d'intermétalliques présente l'inconvénient de nécessiter des moyens lourds et des durées de fabrication importantes (plusieurs heures.) Par ailleurs, les intermétalliques ne permettent d'assembler que des boîtiers métalliques présentant une grande pureté et compatibles avec les intermétalliques.

Un autre but de l'invention est de proposer un procédé d'assemblage hermétique d'un boîtier électronique qui soit facile à mettre en oeuvre et qui ne détériore pas les performances électroniques des fonctions électroniques comprises dans le boîtier.

L'invention a pour objet un procédé d'assemblage hermétique d'un boîtier électronique logeant un (ou des) composant(s) électronique(s), comprenant les étapes suivantes :
- une étape d'assemblage du boîtier en mettant en contact un support, auquel est fixé le(s) composant(s) électronique(s), et un capot par l'intermédiaire d'un mélange comprenant une pâte et des nanoparticules de taille comprise entre 10 et 30 nm en suspension dans ladite pâte,
- une étape de fermeture hermétique du boîtier en portant le boîtier à une température T permettant le frittage des nanoparticules métalliques comprise entre 150 et 180 °C et à une pression au moins égale à 2,5 10⁵ Pa.

Le procédé selon l'invention comprend éventuellement les caractéristiques suivantes, prises seules ou en combinaison :
- la température T est appliquée pendant une durée D supérieure ou égale à 10 minutes et de préférence comprise entre 10 et 30 minutes,
- la température T est appliquée de manière ponctuelle à la jonction entre le capot et le support au moyen d'une source de température que l'on déplace le long de la jonction,
- la source de température est une source laser,
- la pâte comprend au moins un solvant organique,
- le mélange comprend une concentration volumique de nanoparticules comprise entre 70% à 90%,
- il comprend, préalablement à l'étape d'assemblage du boîtier, une étape de fixation du (ou des) composant(s) électroniques sur le support.

Un deuxième mode de réalisation du procédé selon l'invention est tel que l'étape d'assemblage du boîtier comprend une étape de dépôt d'une pâte sur le support, et une étape de mise à contact du support et du capot par l'intermédiaire de la pâte.

Par ailleurs, l'étape de fermeture hermétique du boîtier en portant le boîtier à une température T permettant le frittage des nanoparticules métalliques comprise ente 150 °C. et 180 °C, en mettant le boîtier sous une pression au moins égale à 2,5 10⁵ Pa comprend :
- une première étape d'application d'une source laser à la verticale sur ladite pâte déposée sur le support, préalablement à l'étape de mise en contact du support et du capot, de façon à éliminer l'éventuel solvant compris dans la pâte et à amorcer le frittage,
- une deuxième étape d'application du laser à l'horizontal sur ladite pâte, ultérieure à l'étape de mise en contact du support et du capot par l'intermédiaire de la pâte.

L'invention présente l'avantage de proposer un boîtier électronique présentant une bonne résistance mécanique, encapsulant des fonctions électroniques performantes. Par ailleurs, le boîtier selon l'invention est obtenu au moyen d'un procédé qui ne risque pas de détériorer les fonctions électroniques réalisées par les composants compris dans le boîtier. La fermeture du boîtier est simple à mettre en oeuvre et ne nécessite pas d'équipements lourds.

D'autres caractéristiques et avantages de l'invention apparaîtront à la lecture de la description détaillée qui suit, faite à titre d'exemple non limitatif et en référence aux dessins annexés dans lesquels :
- la figure 1 représente schématiquement en perspective, l'extérieur d'un boîtier électronique hermétique d'un premier exemple de boîtier selon l'invention,
- la figure 2 représente schématiquement une coupe du boîtier de la figure 1, selon un plan globalement vertical M du boîtier,
- la figure 3 représente, schématiquement une coupe selon un plan globalement vertical d'un deuxième exemple de boîtier selon l'invention,
- les figures 4a et 4b représentent schématiquement une coupe selon un premier plan globalement vertical, et respectivement, selon un deuxième plan globalement vertical et perpendiculaire au premier plan vertical, d'un troisième exemple de boîtier selon l'invention,
- les figures 5a, 5b, 5c représentent schématiquement les étapes du procédé selon l'invention.

D'une figure à l'autre, les mêmes éléments sont repérés par les mêmes références.

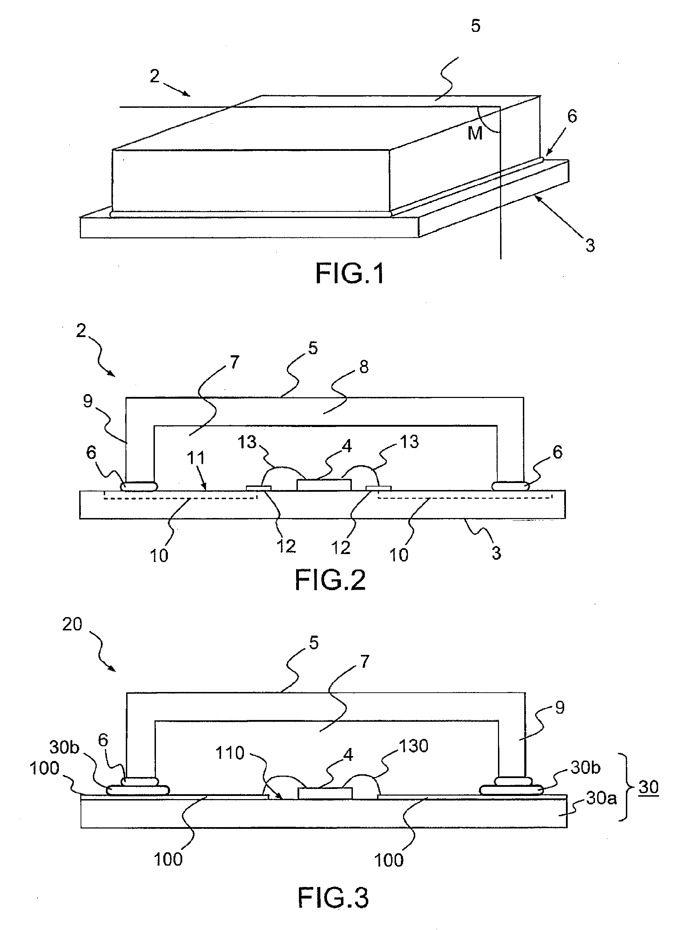

Sur la figure 1, on a représenté en perspective l'extérieur d'un boîtier électronique 2 hermétique, globalement parallélépipédique, d'un premier exemple de boîtier selon l'invention. Le boîtier électronique hermétique 2 comprend un support 3 et un capot 5 agencés de sorte à former une paroi délimitant une cavité 7 logeant un composant électronique 4 (représentés sur la figure 2) fixé audit support 3. Le support 3 et le capot 5 sont joints hermétiquement au moyen d'un joint 6 comprenant un agglomérat de nanoparticules métalliques. La structure des agglomérats est du type mésoscopique.

Sur la figure 2, on a représenté schématiquement une coupe du boîtier représenté sur la figure 1, dans le plan vertical M. Le boîtier électronique 2 comprend un capot 5 et un support 3 auquel est fixé un composant électronique 4. Sur le mode de réalisation représenté la figure 2, le support 3 forme un fond présentant la forme d'une plaque globalement plane. Le support 3 présente en outre une fonction de substrat, le composant électronique 4 étant fixé (c'est à dire placé, reporté, intégré) sur la face supérieure 11 du support 3. On dit que boîtier est à fond intelligent.

Avantageusement, le support 3 est réalisé en céramique. Sur le mode de réalisation de la figure 2, le support 3 est, par exemple, un substrat céramique multi-couches intégrant des vias conducteurs 10 (représentés en traits pointillés) réalisés dans le substrat assurant l'interconnexion électrique entre le composant électronique 4 et l'extérieur de la cavité 7. Le composant électronique est relié électriquement aux conducteurs 10 par l'intermédiaire de moyens de liaison électriques 13 reliés à des plots conducteurs 12 eux-mêmes reliés aux vias conducteurs 10.

Le capot 5 présente une forme de cuvette. La cuvette est retournée de sorte que son ouverture est orientée vers le support 3. Plus précisément, la cuvette est retournée vers la face supérieure 11 du support 3. Elle comporte un fond 8 et un bord périphérique 9. Le bord périphérique 9 de la cuvette vient reposer sur le support 3, plus précisément sur sa surface supérieure 11 (qui est la surface du support qui est orientée vers le capot), par l'intermédiaire d'un joint hermétique 6 qui joint hermétiquement le capot 5 avec le support 3. La cuvette enveloppe à distance le composant électronique 4. En d'autres termes, la cavité est délimitée dans sa partie basse par le fond 3, dans sa partie haute par le fond 8 du capot 5 et dans sa partie latérale par le bord périphérique 9 s'étendant depuis le fond 8 jusqu'au capot 5.

Le joint hermétique 6 assure la jonction mécanique et hermétique entre le support 3 et le capot 5. Le joint 6 comprenant des agglomérats de nanoparticules métalliques est avantageusement obtenu par frittage de nanoparticules métalliques comme nous le décrirons par la suite.

Sur la figure 3, on a représenté schématiquement une coupe dans un plan vertical, d'un deuxième exemple de boîtier électronique selon l'invention présentant globalement la même forme qu'un boîtier représenté sur la figure 1. Dans ce mode de réalisation, le support 30 comprend un fond 30a et un rebord périphérique isolant électriquement 30b. Le rebord isolant 30b du support est fixé hermétiquement au fond 30a, plus particulièrement à la face supérieure 110 du fond 30a (qui est la surface du fond qui est orientée vers le capot). Plus précisément, le rebord isolant est fixé directement au fond sur certaines portions et par l'intermédiaire des pistes conductrices 100 qui s'interposent entre le fond et le rebord sur les autres portions. Le rebord isolant est réalisé en matériau isolant électriquement, par exemple, en verre dit basse température. Le rôle de substrat est joué par le fond 30a auquel est fixé le composant électronique 4. Le substrat 30a n'est pas, dans ce mode de réalisation, un substrat multi-couches. Il s'agit par exemple d'un substrat céramique ou autre matériau inorganique comme le quartz, le saphir ou autre. Les interconnexions entre le composant électronique 4 et l'extérieur sont réalisées en surface du fond 30a au moyen de pistes conductrices 100 s'étendant sur la surface supérieure 110 du fond 30a et débouchant à l'extérieur de la cavité en passant sous le matériau isolant 30b. Le composant électronique 4 est relié aux pistes conductrices 100 au moyen de moyens de liaison électriques 130.

Dans ce mode de réalisation, le bord périphérique 9 de la cuvette, vient reposer sur le support 30, plus précisément sur le rebord isolant 30b du support, par l'intermédiaire d'un joint hermétique 6 joignant hermétiquement le capot 5 avec le support 30. Avantageusement, le rebord isolant 30b présente, dans un plan horizontal, c'est-à-dire dans un plan parallèle au fond 30a, une forme globalement identique à celle du bord périphérique, par exemple globalement rectangulaire ou circulaire. Les largeurs des deux rebords, dans le plan horizontal, ne sont pas nécessairement identiques. Ainsi, la cuvette repose sur le rebord 30b sur toute sa périphérie. En d'autres termes, la cavité est délimitée dans sa partie basse par le fond 30a, dans sa partie haute par le fond 8 du capot 5 et dans sa partie latérale par le bord périphérique 9 et le rebord isolant 30b.

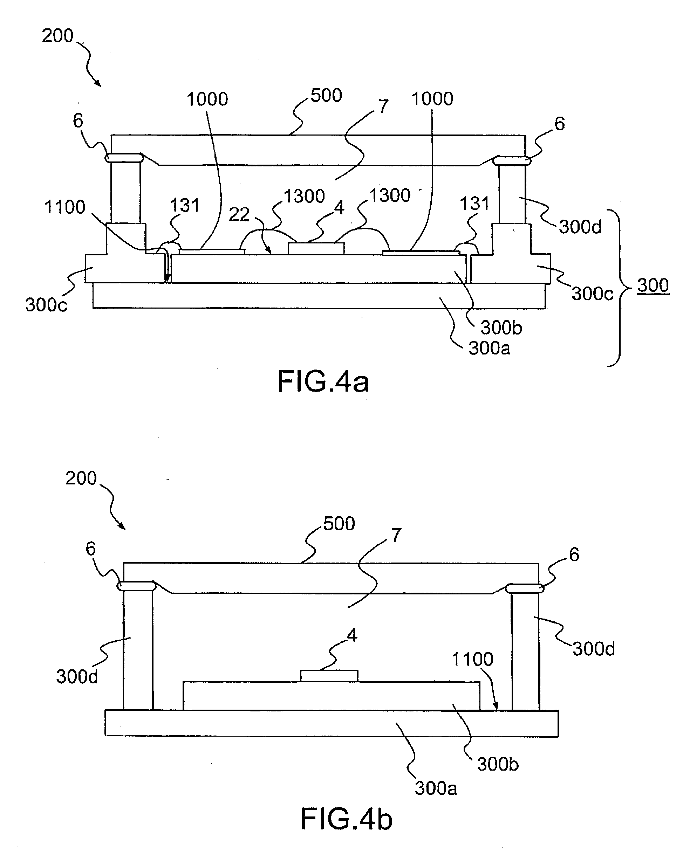

Les figures 4a et 4b représentent schématiquement une coupe selon un premier plan globalement vertical, et respectivement, selon un deuxième plan globalement vertical et perpendiculaire au premier plan vertical, d'un boîtier 200 selon un troisième mode de réalisation de l'invention. Le support 300 présente la forme d'une cuvette. Il comprend un fond 300a, un substrat 300b fixé sur la surface supérieure 1100 du fond 300a. Dans ce mode de réalisation, le fond 300a est par exemple réalisé en matériau métallique, le plus souvent en Ferro-Nickel-Cobalt, en Cuivre-Tungstène ou en matériau fortement conducteur thermiquement. Le substrat 300b est, par exemple, réalisé en céramique et, plus généralement, en matériau diélectrique.

Le composant électronique 4 est fixé sur la face supérieure 22 (c'est-à-dire orientée en direction du support) du substrat 300b. L'interconnexion entre l'intérieur et l'extérieur de la cavité est réalisée au moyen d'inserts céramiques (ou traversées) 300c fixés hermétiquement au fond 300a, par exemple, par brasure. Le composant électronique 4 est relié au inserts céramiques 300c au moyen de premières liaisons électriques 1300, reliant le composant 4 à des pistes 1000 formées sur la surface supérieure du substrat conducteur 300b et de deuxièmes liaisons électriques 131 reliant les pistes 100 aux inserts 300c. Le support 300 comprend en outre un cadre 300d fixé hermétiquement aux inserts 300c et au fond 300b. Le cadre est conducteur. Il est, par exemple, réalisé en métal.

Le cadre métallique 300d forme un bord à la périphérie du fond 300a. Les jonctions entre le cadre 300d et avec, d'une part, les inserts 300c et, d'autre part, le fond 300a sont, par exemple, réalisées par brasure. Dans ce mode de réalisation, le capot 500 présente la forme d'une plaque, par exemple, globalement rectangulaire. Elle est rapportée sur le cadre métallique 300d et jointe au support 300, plus particulièrement au cadre 300d au moyen d'un joint 6 réalisant la jonction hermétique entre le support 300 et le capot 500. Le cadre périphérique 300d s'étend entre le capot 500 et alternativement le fond 300a et les inserts 300c. La cavité 7 est délimitée dans sa partie basse par le substrat 300b et le fond 300a qui se font face, dans sa partie haute par le capot et dans sa partie latérale par le cadre 300d et les inserts 300c.

Sur les figures précédentes, on a représenté un boîtier électronique comprenant un unique composant électronique mais il peut bien sûr comprendre plusieurs composants électroniques 4. Les composants électroniques 4 fixés au support 3, 30, 300 et accueillis au sein de la cavité peuvent être de différents types comme par exemple des composants passifs, des composants actifs, des microsystèmes. L'invention est particulièrement intéressante pour les composants susceptibles d'être dégradés à température élevée, c'est-à-dire à une température supérieure à 200°C. C'est le cas des systèmes microélectromécaniques MEMS (acronyme de l'expression anglo-saxonne "Micro-Electro-Mechanical Systems".)

Un boîtier selon l'invention présente une taille comprise entre 1mm³ et plusieurs cm³. L'invention proposée est particulièrement intéressante dans le cas des boîtiers délimitant de très petites cavités (boîtiers de petite taille de l'ordre du mm³) car ils ne sont pas compatibles avec les procédés de fermeture à la molette.

Les essais de cisaillement permettent, d'une manière générale, la caractérisation d'un joint. Pour un boîtier présentant un joint 6 comprenant des agglomérats de nanoparticules métalliques, la demanderesse à constaté que le cisaillement de l'interface se fait dans le joint lui-même, ce qui garantit la bonne adhésion entre le joint et les surfaces du support et du capot à assembler.

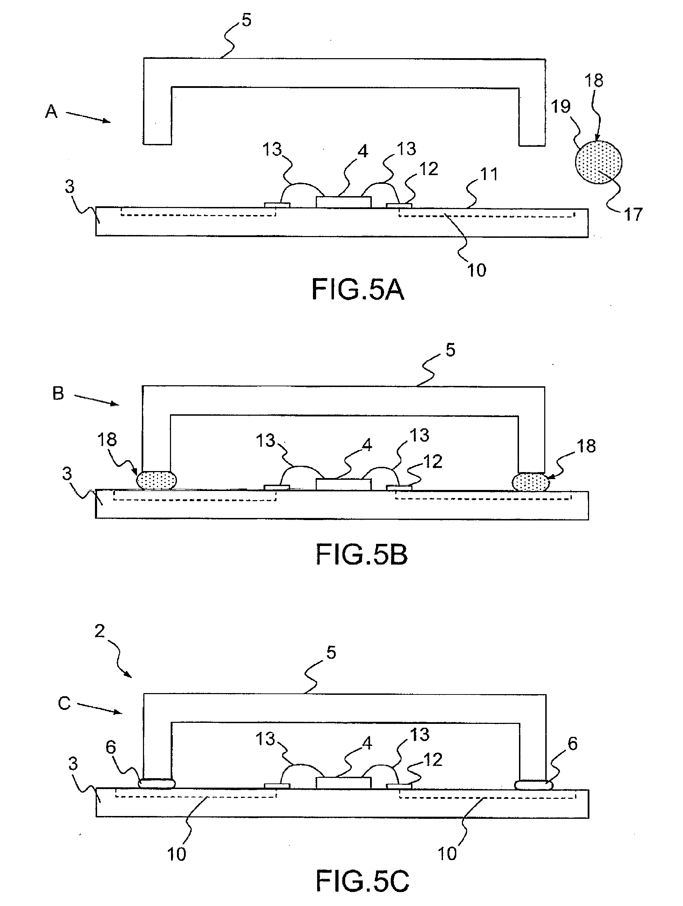

On va maintenant décrire les étapes du procédé d'assemblage hermétique du boîtier électronique 2 selon l'invention. Comme représenté sur les figures 5a, 5b, 5c représentant schématiquement un exemple d'étapes respectives d'un procédé d'assemblage hermétique d'un boîtier électronique 2 selon le premier mode de réalisation. Dans le procédé selon l'invention, on dispose A dans un premier temps d'un capot 5 et d'un support 3, auquel est fixé au moins un composant 4. Les connexions entre l'intérieur et l'extérieur du boîtier sont également réalisées

Le procédé comprend les étapes suivantes :
- une étape B d'assemblage du boîtier 2 en mettant en contact le support 3, auquel est fixé le(s) composant(s) électronique(s) 4, et le capot 5 par l'intermédiaire d'un mélange 18 comprenant une pâte 19 et des nanoparticules 17 en suspension dans ladite pâte 19,
- une étape C de fermeture hermétique du boîtier en portant le boîtier 2 à une température T permettant le frittage des nanoparticules métalliques.

Le mélange est avantageusement appliqué à l'interface entre le support et le capot. L'étape d'assemblage comprend avantageusement une étape d'application, non représentée, du mélange 18 sur le support 3 et/ou sur le capot 5, à l'interface entre ledit capot 5 et ledit support 3.

Dans le dispositif selon le premier mode de réalisation, l'interface entre le capot 5 et le support 3 comprend le bord inférieur du capot 5 (c'est-à-dire la partie du bord périphérique 9, orientée face au support) et une partie de la périphérie de la surface supérieure 11 du fond 3a présentant la même forme que le bord inférieur du capot 5. Le procédé selon l'invention est également mis en oeuvre pour assembler les boîtiers représentés sur les figures 3, 4a et 4b. L'interface entre le capot et le support du boîtier représenté sur la figure 3, comprend le bord inférieur du capot 5 ainsi que le bord supérieur du rebord isolant 30b (c'est-à-dire le bord du rebord isolant qui est orienté face au capot 5). L'interface entre le capot et le support du boîtier représenté sur les figures 4a et 4b comprend le bord supérieur du cadre 300d (c'est-à-dire le bord du cadre orienté face au capot) ainsi qu'une partie de la périphérie du capot 500 présentant la même forme que le bord supérieur du cadre 300d.

La pâte 19 comprend avantageusement un ou plusieurs solvants organiques. Le solvant organique est par exemple du terpinéol, de l'alpha-terpinéol, du toluène, de l'hexane ou du xylène. Le solvant organique sert à transporter des nanoparticules et à éviter l'agglomération de ces nanoparticules 17. Ces composés organiques peuvent être liants et/ou dispersants. Le mélange 18 comprend, de préférence, une concentration volumique de nanoparticules métalliques 17 comprise entre 70% et 90 % et une concentration volumique de solvant comprise entre 10 et 30%. Ces concentrations permettent d'obtenir le frittage.

Avantageusement, la température d'évaporation des solvants est inférieure à la température T.

Par nanoparticule, on entend une particule dont la taille est comprise entre 10 et 100 nm. La taille des nanoparticules est de préférence comprise entre 10 nm et 30 nm. Par taille on entend le diamètre des nanoparticules. C'est la taille nanométrique des particules qui permet de réaliser le frittage à basse température. Plus les particules sont petites, moins la température de frittage est élevée, mais avec une limite basse car, lorsque les nanoparticules sont trop petites, le joint obtenu peut être électriquement conducteur. Avec des nanoparticules de taille supérieure à 30 nm, la demanderesse a constaté qu'il est impossible de réaliser le frittage à une température inférieure à 200°C aux pressions utilisées, par exemple à 2,5 bar. La température de frittage des particules augmente en effet lorsque la taille des nanoparticules augmente.

La pâte est avantageusement préparée par un procédé comprenant une étape de fabrication des nanoparticules à partir d'une solution colloïdale stabilisée ou par décomposition d'un précurseur ou par une autre méthode, une étape de préparation et récupération de la poudre de nanoparticules et une étape de dispersion des nanoparticules dans le solvant (par exemple par un procédé à ultrasons qui permet une dispersion homogène sans engendrer de frittage des nanoparticules.)

Les nanoparticules métalliques sont préférentiellement des particules d'argent Ag. L'argent est particulièrement intéressant car il est compatible (pas de phénomène électrolytique) avec différents matériaux susceptibles d'être compris dans le capot et dans les parties du support en contact avec le capot à savoir l'étain Sn, l'or Au, et/ou le Nickel Ni. L'argent possède des caractéristiques physiques (structure cristalline, rayon atomique, électronégativité, etc.) et chimiques (peu oxydable, etc.) extrêmement proches de l'or. D'après les règles de Hume-Rothery, qui permettent la prédiction de la formation de solutions solides stables dans de larges gammes de compositions, lorsque le capot et le support comprennent de l'or à leur interface, l'or et l'argent forment un alliage à solubilité complète (confirmé par leur diagramme d'équilibre), et a fortiori non fragile puisque stable en toute composition (pas de création d'intermétalliques entre l'or et l'argent). On assure ainsi une bonne tenue mécanique du boîtier. Les nanoparticules métalliques peuvent également être des nanoparticules de cuivre, d'or, d'un autre métal ou d'un alliage métallique. Lorsque le boîtier 2 est porté à la température T, les nanoparticules 17 comprises dans le mélange s'agglomèrent. On parle de densification par frittage. Elles forment également des liaisons mécaniques avec, d'une part, le support 3 et, d'autre part, le capot 5 de sorte que les agglomérats de nanoparticules 17 réalisent une jonction mécanique entre le capot et le support. Les liaisons mécaniques entre les nanoparticules et le support 3 et/ou le capot peuvent être d'origine chimique ou uniquement mécanique (par exemple par pénétration de nanoparticules métalliques au sein d'orifices formées à la surface du capot et du support.) Lorsque la surface du support 3 et/ou respectivement du capot 5, située à l'interface avec le mélange 18 comprend de l'or (cas de support et/ou de capot métalliques comprenant un peu d'or), des nanoparticules d'argent comprises dans le joint forment avantageusement, avec l'or situé à l'interface entre une pièce et le joint, un alliage or-argent qui lie mécaniquement la pièce concernée et le joint (liaison d'origine chimique.)

Après application de la température de frittage, au moins une partie des solvants est sont évaporée, le joint 6 situé à la jonction entre le support et le capot comprend des nanoparticules agglomérées et des pores ainsi qu'éventuellement des liaisons chimiques établies entre le métal constituant les nanoparticules et des composants du support. Plus particulièrement, le joint comprend une concentration volumique de nanoparticules agglomérées comprise entre 65% à 80% et une grande partie des 20% à 35% restant comprend des pores.

La demanderesse a mis en évidence que le joint 6 forme une jonction hermétique entre le support et le capot. En effet, la demanderesse a réalisé un test de Fine Fuite sur un boîtier électronique selon le premier mode de réalisation dans une chambre pressurisée à l'Hélium. Elle a mesuré un taux de fuite de l'Hélium de l'ordre de 10⁻⁷ atm cm³/s. Or, on considère classiquement qu'un boîtier présente une bonne herméticité lorsque le taux de fuite de l'Hélium est compris entre 10⁻⁷ et 10⁻⁸atm.cm³/s suivant le volume de la cavité hermétique sachant qu' 1 atm.cm³ est égal à 1 mbar. Ainsi, le joint poreux 6 forme une liaison hermétique entre le support et le capot. La densification intervient à l'évaporation des solvants. La densification intervient d'abord en périphérie du joint, où le solvant peut s'échapper plus facilement. Cette densification en périphérie peut alors bloquer le passage pour l'évaporation du solvant à l'intérieur du joint. Du solvant peut rester au coeur du joint, limitant à cet endroit la densification. Ainsi le joint 6 présentant des agglomérats de nanoparticules métalliques 17 au moins dans sa périphérie.

La température T permettant le frittage des nanoparticules du mélange est comprise entre 150 et 250°C de sorte à ne pas détériorer les composants électroniques fixes au support 3. L'avantage fondamental lié à cette faible température de frittage est l'absence de détérioration des fonctions réalisées par les composants électroniques lors de la formation du joint hermétique. Par ailleurs, le procédé est simple à mettre en oeuvre. Le boîtier hermétique assemblé est en outre, après frittage, capable de supporter des températures nettement supérieures: environ 800°C pour un frittage à 180°C de nanoparticules d'argent. De préférence, la température de T est comprise entre 150°C et 180°C. A ces températures on s'assure que les composants de type MEMS ne sont pas détériorés. Plus les nanoparticules sont petites, plus le choix d'une faible température T est possible.

De préférence, lorsqu'on porte le boîtier 2 assemblé au moyen du mélange 18, à la température T permettant le frittage, on exerce sur le boîtier une force de compression maintenant le support et le capot l'un contre l'autre. De préférence, la pression exercée est de l'ordre de 0 à 300 grammes-force (gravet), où 1 gravet est égal à 9,80665 mN.

Plus la force de compression appliquée est importante, plus le joint est dense, c'est-à-dire solide et hermétique. L'application d'une forte pression sur le boîtier permet en outre de diminuer la durée D d'application de la température de frittage et/ou de diminuer la température T.

Par ailleurs, pendant l'application de la température de frittage on met avantageusement le boîtier sous une pression au moins égale à 2, 5 bars, c'est-à-dire 2,5 10⁵ Pascals. Par exemple, la pression est égale à 2 bars.

En dessous de 2, 5 bars, la demanderesse a constaté qu'il n'est pas possible d'obtenir la fusion ni la densification nécessaire à l'obtention d'un joint hermétique.

La demanderesse a plus particulièrement constaté que l'obtention d'un joint hermétique n'est possible à des températures comprises entre 150 et 180 °C permettant d'assurer l'absence de détérioration des composants électroniques, qu'à une pression au moins égale à 2,5 bar et en utilisant des nanoparticules de taille comprise entre 10 et 30 nm. En dehors de ces intervalles, l'utilisation d'une température supérieure est nécessaire.

Avantageusement la température est appliquée de manière ponctuelle à la jonction entre le capot et le support au moyen d'une source de température que l'on déplace le long de la jonction, par exemple, une source laser.

Avantageusement, on porte le boîtier à la température T pendant une durée D prédéterminée de sorte à permettre le frittage des nanoparticules métalliques 7 et l'évaporation maximale des solvants de la pâte 19. De préférence, la durée d'application D de la température T est supérieure ou égale à 10 minutes et de préférence comprise entre 10 et 30 minutes. Plus la taille des nanoparticules est faible, plus on peut choisir une température T faible et /ou une durée D faible.

Avantageusement, on adapte la pression, la température T de frittage et la durée D d'application de la température T en fonction de la résistance des composants électroniques, de la résistance des liaisons entre les composants et le substrat, en fonction de la résistance mécanique, de l'herméticité du boîtier recherchées et en fonction de la taille des nanoparticules.

Avantageusement, le procédé selon l'invention comprend, préalablement à l'étape d'application d'une pâte 18, une étape de fixation du (ou des) composant(s) électronique(s) 4 audit support et éventuellement une étape d'établissement des liaisons électriques dans le boîtier.

Dans les modes de réalisation représentés sur les figures 3, 4a et 4b, le procédé d'assemblage selon l'invention comprend avantageusement, préalablement à l'étape d'assemblage du boîtier, une étape d'assemblage du support, c'est à dire une étape d'assemblage des pièces constituant le support 30, 300. Avantageusement, l'étape de fixation du (ou des) composant(s) au support est réalisée utlérieurement à cette étape de sorte que l'étape d'assemblage du support ne détériore pas les fonctions réalisées par les composants.

Le procédé selon l'invention permet d'obtenir un joint différent d'une soudure ou d'un amalgame. L'agrégation (frittage) se rapproche d'une soudure locale au niveau des joints mais sans refusion des nanoparticules métalliques. Le frittage est un procédé de densification par diffusion à l'état solide sans refusion.

Un deuxième mode de réalisation du procédé selon l'invention est tel que l'étape d'assemblage du boîtier comprend une étape de dépôt d'une pâte sur le support, et une étape de mise à contact du support et du capot par l'intermédiaire de la pâte.

Par ailleurs, l'étape de fermeture hermétique du boîtier en portant le boîtier à une température T permettant le frittage des nanoparticules métalliques comprise ente 150 °C. et 180 °C, en mettant le boîtier sous une pression au moins égale à 2,5 10⁵ Pa comprend :
- une première étape d'application d'une source laser à la verticale sur ladite pâte déposée sur le support, préalablement à l'étape de mise en contact du support et du capot, de façon à éliminer l'éventuel solvant compris dans la pâte et à amorcer le frittage,
- une deuxième étape d'application du laser à l'horizontal sur ladite pâte, ultérieure à l'étape de mise en contact du support et du capot par l'intermédiaire de la pâte.

## Revendications

1. Procédé d'assemblage hermétique d'un boîtier électronique (2, 20, 200) logeant un (ou des) composant(s) électronique(s) (4), **caractérisé en ce que** ledit procédé comprend les étapes suivantes :
- une étape (B) d'assemblage du boîtier (2, 20, 200) en mettant en contact un support (3), auquel est fixé le(s) composant(s) électronique(s) (4), et un capot (5) par l'intermédiaire d'un mélange (18) comprenant une pâte (19) et des nanoparticules (17) en suspension dans ladite pâte (19), la taille des nanoparticules étant comprise entre 10 et 30 nm,
- une étape (C) de fermeture hermétique du boîtier (2, 20, 200) en portant le boîtier (2, 20, 200) à une température T permettant le frittage des nanoparticules métalliques (17) comprise entre 150 °C. et 180 °C, en mettant le boîtier sous une pression au moins égale à 2,5 10⁵ Pa.

2. Procédé d'assemblage hermétique d'un boîtier électronique (2, 20, 200) selon la revendication 1, **caractérisé en ce que** la température T est appliquée pendant une durée D supérieure ou égale à 10 minutes ou comprise entre 10 et 30 minutes.

3. Procédé d'assemblage hermétique d'un boîtier électronique (2, 20, 200) selon l'une quelconque des revendications précédentes, **caractérisé en ce que** la température T est appliquée de manière ponctuelle à la jonction entre le capot et le support au moyen d'une source de température que l'on déplace le long de la jonction.

4. Procédé d'assemblage hermétique d'un boîtier électronique (2, 20, 200) selon l'une quelconque des revendications précédentes, **caractérisé en ce que** la source de température est une source laser.

5. Procédé d'assemblage hermétique d'un boîtier électronique selon la revendication précédente, dans lequel l'étape d'assemblage du boîtier comprend une étape de dépôt d'une pâte sur le support et une étape de mise à contact du support et du capot par l'intermédiaire de la pâte; l'étape de fermeture hermétique du boîtier en portant le boîtier à une température T permettant le frittage des nanoparticules métalliques comprise ente 150 °C. et 180 °C, en mettant le boîtier sous une pression au moins égale à 2,5 10⁵ Pa comprenant une première étape d'application d'une source laser à la verticale sur ladite pâte déposée sur le support, préalablement à l'étape de mise en contact du support et du capot, de façon à éliminer un éventuel solvant compris dans la pâte et à amorcer le frittage, et une deuxième étape d'application du laser à l'horizontal sur ladite pâte, ultérieurement à l'étape de mise en contact du support et du capot par l'intermédiaire de la pâte.

6. Procédé d'assemblage hermétique d'un boîtier électronique (2, 20, 200) selon l'une quelconque des revendications précédentes, **caractérisé en ce que** la pâte (19) comprend au moins un solvant organique.

7. Procédé d'assemblage hermétique d'un boîtier électronique (2, 20, 200) l'une quelconque des revendications précédentes, **caractérisé en ce que** le mélange (18) comprend une concentration volumique de nanoparticules comprise entre 70% à 90%.

8. Procédé d'assemblage hermétique d'un boîtier électronique (2, 20, 200) selon l'une quelconque des revendications précédentes, **caractérisé en ce qu'**il comprend, préalablement à l'étape d'assemblage du boîtier, une étape de fixation du (ou des) composant(s) électroniques sur le support.

## Patentansprüche

1. Verfahren zum hermetisch dichten Zusammenfügen eines elektronischen Gehäuses (2, 20, 200), das eine (oder mehrere) elektronische Komponente(n) (4) aufnimmt, **dadurch gekennzeichnet, dass** das Verfahren die folgenden Schritte beinhaltet:
- einen Schritt (B) des Zusammenfügens des Gehäuses (2, 20, 200), indem eine Auflage (3), auf der die eine oder mehreren elektronische(n) Komponente(n) (4) montiert ist/sind, und eine Abdeckung (5) mit einer Mischung (18) in Kontakt gebracht werden, die eine Paste (19) und in der Paste (19) suspendierte Nanopartikel (17) umfasst, wobei die Größe der Nanopartikel zwischen 10 und 30 nm liegt;
- einen Schritt (C) des hermetisch dichten Verschließens des Gehäuses (2, 20, 200) durch Bringen des Gehäuses (2, 20, 200) auf eine Temperatur T zwischen 150°C und 180°C, die das Sintern von Metallnanopartikeln (17) zulässt, wobei das Gehäuse einem Druck ausgesetzt wird, der wenigstens gleich 2,5 x 10⁵ Pa ist.

2. Verfahren zum hermetisch dichten Zusammenfügen eines elektronischen Gehäuses (2, 20, 200) nach Anspruch 1, **dadurch gekennzeichnet, dass** die Temperatur T für eine Dauer D appliziert wird, die gleich oder größer als 10 Minuten ist oder zwischen 10 und 30 Minuten liegt.

3. Verfahren zum hermetisch dichten Zusammenfügen eines elektronischen Gehäuses (2, 20, 200) nach einem der vorherigen Ansprüche, **dadurch gekennzeichnet, dass** die Temperatur T punktförmig auf den Übergang zwischen der Abdeckung und der Auflage mit einer Temperaturquelle appliziert wird, die sich längs des Übergangs bewegt.

4. Verfahren zum hermetisch dichten Zusammenfügen eines elektronischen Gehäuses (2, 20, 200) nach einem der vorherigen Ansprüche, **dadurch gekennzeichnet, dass** die Temperaturquelle eine Laserquelle ist.

5. Verfahren zum hermetisch dichten Zusammenfügen eines elektronischen Gehäuses nach dem vorherigen Anspruch, wobei der Schritt des Zusammenfügens des Gehäuses einen Schritt des Absetzens einer Paste auf die Auflage und einen Schritt des Inkontaktbringens der Auflage und der Abeckung mittels der Paste beinhaltet, wobei der Schritt des hermetisch dichten Verschließens des Gehäuses durch Bringen des Gehäuses auf eine Temperatur zwischen 150°C und 180°C, die das Sintern von Metallnanopartikeln (17) zulässt, wobei das Gehäuse einem Druck ausgesetzt wird, der wenigstens gleich 2,5 x 10⁵ Pa ist, einen ersten Schritt des vertikalen Applizierens einer Laserquelle auf die auf die Auflage abgesetzte Paste vor dem Schritt des Inkontaktbringens der Auflage und der Abdeckung, um eventuelles in der Paste enthaltenes Lösungsmittel zu entfernen und das Sintern zu starten, sowie einen zweiten Schritt des horizontalen Applizierens des Lasers auf die Paste nach dem Schritt des Inkontaktbringens der Auflage und der Abdeckung mittels der Paste beinhaltet.

6. Verfahren zum hermetisch dichten Zusammenfügen eines elektronischen Gehäuses (2, 20, 200) nach einem der vorherigen Ansprüche, **dadurch gekennzeichnet, dass** die Paste (19) wenigstens ein organisches Lösungsmittel beinhaltet.

7. Verfahren zum hermetisch dichten Zusammenfügen eines elektronischen Gehäuses (2, 20, 200) nach einem der vorherigen Ansprüche, **dadurch gekennzeichnet, dass** die Mischung (18) eine Nanopartikel-Volumenkonzentration zwischen 70 und 90 % aufweist.

8. Verfahren zum hermetisch dichten Zusammenfügen eines elektronischen Gehäuses (2, 20, 200) nach einem der vorherigen Ansprüche, **dadurch gekennzeichnet, dass** es vor dem Schritt des Zusammenfügens des Gehäuses einen Schritt des Montierens der einen (oder mehreren) elektronischen Komponente(n) auf der Auflage beinhaltet.

## Claims

1. A method for the hermetic assembly of an electronic housing (2, 20, 200) that houses one (or more) electronic component(s) (4), **characterised in that** said method comprises the following steps:
- a step (B) of assembling said housing (2, 20, 200) by bringing into contact a support (3), on which the one (or more) electronic component(s) (4) is/are mounted, and a cover (5) by using a mixture (18) comprising a paste (19) and nanoparticles (17) suspended in said paste (19), with the size of said nanoparticles being between 10 and 30 nm;
- a step (C) of hermetically sealing said housing (2, 20, 200) by heating said housing (2, 20, 200) to a temperature T of between 150°C and 180°C that allows the sintering of metal nanoparticles (17), whilst subjecting said housing to pressure that is at least equal to 2.5 x 10⁵ Pa.

2. The method for the hermetic assembly of an electronic housing (2, 20, 200) according to claim 1, **characterised in that** the temperature T is applied for a duration D that is greater than or equal to 10 minutes or is between 10 and 30 minutes.

3. The method for the hermetic assembly of an electronic housing (2, 20, 200) according to any one of the preceding claims, **characterised in that** the temperature T is applied in a dot-shaped manner at the junction between said cover and said support by means of a temperature source that moves along the junction.

4. The method for the hermetic assembly of an electronic housing (2, 20, 200) according to any one of the preceding claims, **characterised in that** the temperature source is a laser source.

5. The method for the hermetic assembly of an electronic housing according to the preceding claim, wherein said step of assembling said housing comprises a step of depositing a paste onto said support and a step of bringing into contact said support and said cover by means of said paste, with said step of hermetically sealing said housing by heating said housing to a temperature of between 150°C and 180°C that allows the sintering of metal nanoparticles (17), whilst subjecting said housing to pressure that is at least equal to 2.5 x 10⁵ Pa, comprising a first step of vertically applying a laser source to said paste deposited onto said support, prior to the step of bringing into contact said support and said cover, so as to remove any solvent contained in said paste and to initiate the sintering, and a second step of horizontally applying the laser to said paste, after the step of bringing into contact said support and said cover by means of said paste.

6. The method for the hermetic assembly of an electronic housing (2, 20, 200) according to any one of the preceding claims, **characterised in that** said paste (19) comprises at least one organic solvent.

7. The method for the hermetic assembly of an electronic housing (2, 20, 200) according to any one of the preceding claims, **characterised in that** said mixture (18) comprises a volume concentration of nanoparticles of between 70% and 90%.

8. The method for the hermetic assembly of an electronic housing (2, 20, 200) according to any one of the preceding claims, **characterised in that** it comprises, before the step of assembling said housing, a step of mounting the one (or more) electronic component(s) onto said support.
